Europäisches Patentamt

(19) European Patent Office

Office européen des brevets

(11) Publication number: **0 132 657**
**A1**

(12) **EUROPEAN PATENT APPLICATION**

(21) Application number: **84107904.9**

(22) Date of filing: **06.07.84**

(51) Int. Cl.⁴: **H 01 J 37/06**

(30) Priority: **21.07.83 US 515847**

(43) Date of publication of application:
**13.02.85 Bulletin 85/7**

(84) Designated Contracting States:
**DE FR GB NL**

(71) Applicant: **THE PERKIN-ELMER CORPORATION**
**Main Avenue**
**Norwalk Connecticut 06856(US)**

(72) Inventor: **Devore, William J.**
**22828 Kings Court**
**Hayward California 94541(US)**

(72) Inventor: **Veneklasen, Lee**
**3445 Badding Road**
**Castro Valley California 94546(US)**

(72) Inventor: **Howard, Glen E.**
**7897 Meadowbrook Court**
**Pleasanton California 94566(US)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 58**
**D-8000 München 22(DE)**

(54) Aperture imaging electron gun.

(57) Disclosed is an electron gun in which the beam shaping aperture, smaller than the source crossover, becomes the object for the succeeding imaging system in an electron beam column of scanning electron microscopes, electron beam lithography machines and the like. The beam forming aperture is located in or near the plane of the anode so that the source crossover alone illuminates the beam forming aperture.

FIG. 2

-1-

APERTURE IMAGING ELECTRON GUN

BACKGROUND OF THE INVENTION

This invention relates to an improvement in electron guns for generating electron beams for use in electron beam apparatus such as a scanning electron microscope or an electron beam lithographic machine and is particularly directed to the formation of an aperture imaging electron gun as distinguished from a crossover imaging electron gun. This invention is particularly important where the electron gun has a cathode of rare earth boride, such as lanthanum hexaboride ($LaB_6$), as the material for the electron emission source.

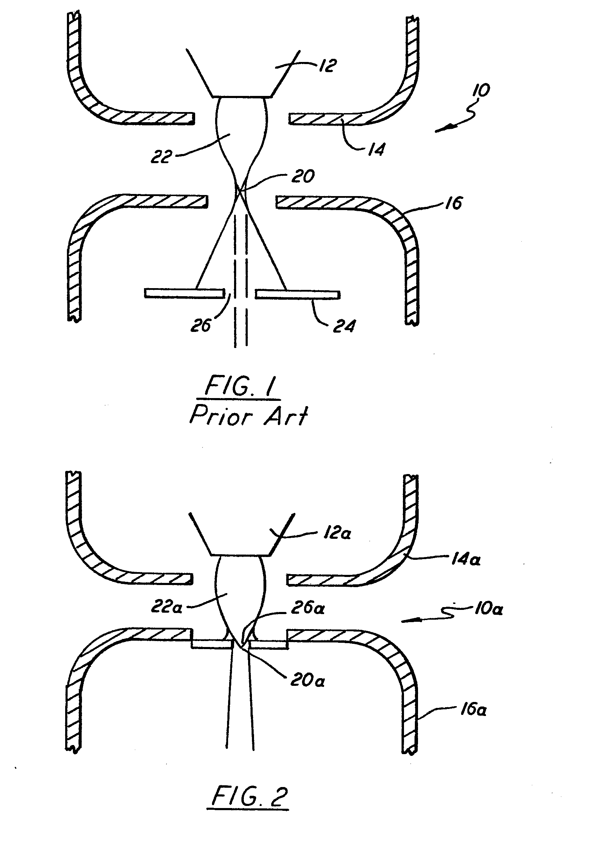

To illustrate the prior art crossover imaging electron gun, reference is made to Figure 1 showing the prior art gun 10 having a $LaB_6$ emitter 12, an apertured Wehnelt electrode 14 (also called a grid cap or control electrode), and an apertured anode 16. When the emitter 12 is heated electrically from a suitable power supply, a crossover point or source 20 in an electron beam 22 is formed between the Wehnelt electrode 14 and the anode 16 and the beam 22 diverges from the crossover point 20 through the aperture in the anode and illuminates a plate 24 having a beam limiting or skimming aperture 26. That portion of the beam exiting from the beam forming aperture is then controlled by a series of electron lenses downstream of the electron gun in a typical electron beam column.

In the prior art electron gun, the beam forming or shaping aperture downstream of the gun is conventionally larger then the diameter of the crossover (which is a function of cathode size position and electrode configuration). If the optics are "Gaussian beam", then the crossover is the object that is imaged by the remainder of the beam column. If the beam forming or shaping aperture is instead the object that is imaged, then the optics are called shaped beam or Koehler mode imaging. In either type of optics, the characteristics of the crossover play an important role in the imaging process. However, it is also known that a rare earth boride cathode, such as $LaB_6$, although highly suitable as a cathode material, is also somewhat reactive at high temperatures at which it operates and at such high temperatures in-gassing and out-gassing varies the electron emission characteristics resulting a change of size, and/or changes in cross-sectional dimension (out of roundness) of the crossover point 20 of the beam. Thus, it is apparent that since the crossover point is important in the prior art gun, and subsequent optics, this change in cross-sectional dimension causes problems
with the beam downstream in the beam column which must
be dealt with.

## SUMMARY OF THE INVENTION

The purpose of this invention is to control
the object size formed by the electron gun independently
of cathode size and position and electrode configuration.
This is accomplished by placing a beam shaping aperture
close to or in the anode plane and in line with the beam
in the electron gun.  The beam shaping aperture is then
illuminated by the source crossover and becomes the object
for the series of electron lenses that follow in the
beam column.  The diameter of this beam forming aperture
is less than the diameter of the source crossover and is
imaged rather than the source crossover as in the prior
art guns.  The uniqueness of the invention lies in the
fact that the aperture is smaller than and lies as close
as possible to the actual gun crossover.

## BRIEF DESCRIPTION OF THE DRAWINGS

Figure 1 illustrates a prior art electron gun, and
Figure 2 illustrates an electron gun constructed
in accordance with the teachings of this invention.

## DETAILED DESCRIPTION

As mentioned above, Figure 1 illustrates a
prior art gun in which the source crossover is imaged
through the beam forming aperture, typically 100 to 400
microns in diameter, which is larger than the crossover
point.  Unfortunately, because of the nature of the rare earth boride cathodes, the source crossover size and cross-sectional dimension and roundness varies and thus, the beam image also varies.

Turning now to Figure 2, wherein those components having the same function as those of Figure 1 are given the same reference numeral, but with the suffix a, there is shown an electron gun 10a, a $LaB_6$ emitter 12a positioned relative to the apertured Wehnelt electrode 14 with the crossover point 20 of the electron beam 22 in approximately the same position from the emitter surface as in the prior art gun 10. However, in this electron gun 10a, the beam forming aperture 26a is positioned in the plane of the anode or, in the embodiment illustrated, forms part of the anode, so that the aperture is then illuminated by the crossover. Being smaller than the crossover in diameter, typically 10 to 25 microns, only that part of the crossover 20 which emerges from the beam forming aperture 26a is imaged and becomes the object for the series of electron lenses which follow in the electron beam column. Thus, the object size of the beam is controlled independently of the cathode size, position and electrode configuration so that variations in cross-sectional dimension of the crossover due to the instability of the emitter have been eliminated.

Stated another way, in this invention, the cathode gun 10a is operated in a near-critical illumination mode with the ratio of crossover diameter to aperture diameter is less than 1, whereas in the prior art gun, the ratio of crossover diameter to aperture diameter is greater than 1. This invention uses an aperture in the gun that is smaller than the crossover as an object (source) for succeeding imaging systems.

The size of the emitter surface, the size of the aperture in the Wehnelt electrode and its distance from the emitter and the distance of the anode from the Wehnelt electrode to allow the crossover to illuminate the beam forming aperture are all within the skill of those in the art.

What is claimed is:

1.      An electron beam apparatus for supplying an electron beam in an electron beam column, comprising,

a rare earth boride cathode emitter for emitting electrons when heated,

an apertured Wehnelt electrode,

a plate with beam forming aperture therein located in the beam path, and

the relationship of the Wehnelt electrode, emitter and anode being such that a source crossover is formed in the beam with the diameter of said beam forming aperture being less than the diameter of the source crossover,

said apertured plate being located near the source crossover so that the source crossover illuminates the beam forming aperture to form an object for the series of electron lenses that follow in the electron beam column.

2.      The electron beam apparatus as claimed in Claim 1 wherein said apertured plate is located in the anode plane

3.      The electron beam apparatus as claimed in Claim 1 wherein said apertured plate forms part of said anode.

4.      The electron beam apparatus as claimed in Claim 1 wherein said apertured plate is close to said anode plane.

5.      The electron beam apparatus as claimed in Claim 1 wherein said rare earth boride is $LaB_6$.

6.      The electron beam apparatus as claimed in Claim 1 wherein said aperture diameter is in the range of 15 to 25 microns.

1/1

FIG. I
Prior Art

FIG. 2

## DOCUMENTS CONSIDERED TO BE RELEVANT

EP 84107904.9

| Category | Citation of document with indication, where appropriate, of relevant passages | Relevant to claim | CLASSIFICATION OF THE APPLICATION (Int Cl 3) 4 |
|---|---|---|---|
| A | <u>EP - A1 - 0 013 738</u> (IBM)<br>   * Fig. 1; page 4, line 10 - page 5, line 20 * | 1 | H 01 J 37/06 |
| A | <u>DE - A1 - 2 815 478</u> (STEIGERWALD)<br>   * Fig. 1; page 5, lines 10-21; claim 1-3 * | 1 | |
| A | <u>DE - B - 1 007 443</u> (VEB CARL ZEISS)<br>   * Fig. 3; column 3, lines 46-60; claim 1 * | 1 | |
| A | <u>GB - A - 1 210 007</u> (MULLARD)<br>   * Fig. 1; page 1, lines 9-34 * | 1 | **TECHNICAL FIELDS SEARCHED (Int Cl 3) 4**<br><br>H 01 J 37/00<br>H 01 J  3/00<br>H 01 J  1/00<br>H 01 J 29/00 |

The present search report has been drawn up for all claims

| Place of search | Date of completion of the search | Examiner |
|---|---|---|
| VIENNA | 24-09-1984 | BRUNNER |